# FASCICULE DE BREVET EUROPEEN

(11) **EP 4 249 453 B1**
(45) Date de publication et mention de la délivrance du brevet: **23.10.2024**
(21) Numéro de dépôt: 23184344.2
(22) Date de dépôt: 20.12.2018
(51) Int. Cl.: C04B 35/628, C23C 16/48, C23C 16/54, C23C 16/32, C23C 16/34, C23C 16/448, C23C 16/46, C23C 18/12, C23C 18/14

(54) **PROCÉDÉ DE DÉPÔT D'UN REVÊTEMENT SUR UNE FIBRE CONTINUE**
VERFAHREN ZUM AUFBRINGEN EINER BESCHICHTUNG AUF EINE KONTINUIERLICHE FASER
METHOD FOR DEPOSITING A COATING ON A CONTINUOUS FIBRE

(30) Priorité: 26.12.2017 FR 1763217
(43) Date de publication de la demande: 27.09.2023
(62) Demande divisionnaire de: 18842444.4
(73) Titulaire: Safran Ceramics, 33185 Le Haillan (FR); Centre National de la Recherche Scientifique, 75016 Paris (FR); UNIVERSITE DE BORDEAUX, 33000 Bordeaux (FR)
(72) Inventeur: DELEHOUZE, Arnaud, 77550 MOISSY-CRAMAYEL (FR); BOUILLON, Eric, 77550 MOISSY-CRAMAYEL (FR); DELCAMP, Adrien, 77550 MOISSY-CRAMAYEL (FR); DESCAMPS, Cédric, 77550 MOISSY-CRAMAYEL (FR)
(74) Mandataire: Cabinet Beau de Loménie

(56) Documents cités:
- JP-A- 2002 252 493
- US-A- 5 543 605
- US-A- 6 152 072
- US-A1- 2011 171 399
- US-A1- 2016 369 400

## Description

### Arrière-plan de l'invention

La présente invention se rapporte au domaine général des procédés de dépôt d'un revêtement sur des fibres, et plus particulièrement sur une fibre continue en carbone ou en carbure de silicium à partir d'un précurseur du revêtement.

Les matériaux composites à matrice céramique (CMC), connus pour leurs bonnes propriétés mécaniques qui les rendent aptes à constituer des éléments de structures et pour conserver ces propriétés à températures élevées, constituent une alternative viable aux traditionnelles pièces métalliques. Leur masse réduite par rapport à leur équivalent métallique en font des pièces de choix pour répondre aux problématiques d'augmentation du rendement et de réduction des émissions polluantes des moteurs dans le domaine aéronautique.

Les pièces en matériau CMC comprennent un renfort fibreux généralement continu sous la forme d'un textile tissé, qui est densifié par une matrice céramique. Le renfort fibreux comprend ainsi des fibres longues continues, regroupées généralement sous la forme de fils ou torons, dont l'orientation peut être adaptée aux directions principales de sollicitation de la pièce lors de son utilisation. La préforme destinée à former le renfort fibreux doit être tissée à partir des torons de fibres continues aux dimensions de la pièce (par exemple par tissage bidimensionnel ou tridimensionnel), à l'aide d'un métier à tisser adapté. Pour réaliser une pièce en matériau CMC qui présente des propriétés mécaniques améliorées, il est connu de disposer de fibres dans la préforme fibreuse qui sont revêtues d'une interphase, préalablement à la densification de la préforme.

On connaît le dépôt d'un revêtement d'interphase sur les fibres d'une préforme fibreuse déjà tissée par infiltration chimique en phase gazeuse (CVI). Outre le coût élevé et les faibles cinétiques de cette technique, l'interphase formée sur les fibres n'est généralement pas homogène et on observe de forts gradients d'épaisseur d'interphase entre la surface et le coeur de la préforme, et localement entre les fibres situées en surface et en coeur de fil ou toron. Cette inhomogénéité du dépôt au sein de la préforme a des conséquences sur les propriétés mécaniques finales de la pièce densifiée, ce qui n'est pas souhaitable.

Il existe donc un besoin pour un procédé de dépôt d'un revêtement sur une fibre continue en carbone ou en carbure de silicium qui soit rapide et forme un revêtement homogène.

US2011/171399 montre un procédé de dépôt d'un revêtement par CVI/CVD sur une fibre continue à partir d'un précurseur du revêtement, le procédé comprenant au moins le chauffage d'un segment de la fibre en présence du précurseur du revêtement dans un champ micro-ondes de façon à porter la surface du segment à une température permettant la formation du revêtement sur le segment à partir du précurseur du revêtement. La fibre peut être une fibre en carbure de silicium.

US6152072 montre la même procédé pour des fibres continues en carbone. US5543605 montre la même procédé pour des fibres continues en carbone ou en SiC.

### Objet et résumé de l'invention

La présente invention a donc pour but principal de pallier de tels inconvénients en proposant un procédé de dépôt d'un revêtement sur une fibre continue en carbone ou en carbure de silicium à partir d'un précurseur du revêtement, le procédé comprenant au moins le chauffage d'un segment de la fibre en présence du précurseur du revêtement dans un champ micro-ondes de façon à porter la surface du segment à une température permettant la formation du revêtement sur le segment à partir du précurseur du revêtement.

Un « segment de fibre » correspond ici à une certaine longueur de fibre, en d'autres termes, le segment s'étend selon la longueur ou la plus grande dimension de la fibre. Une fibre pouvant comprendre plusieurs filaments, un segment de fibre peut comprendre plusieurs filaments. Dans le présent exposé, par « surface du segment », on entend la surface de chaque filament qui compose le segment de fibre, le cas échéant. De manière similaire, on entend par « déposer » ou « former » un revêtement sur le segment de fibre, le dépôt ou la formation du revêtement sur la surface de chaque filament qui compose le segment de fibre, le cas échéant.

Le procédé selon l'invention est remarquable notamment par le fait qu'un segment de la fibre continue est chauffé par couplage direct par l'intermédiaire de micro-ondes. Les inventeurs ont en effet observé que le segment de fibre longue en carbone ou en carbure de silicium couple avec un champ micro-ondes, ce qui permet de porter sa surface à une température suffisante pour former le revêtement à partir d'un précurseur du revêtement. Cette disposition permet de chauffer le segment de fibre dans son ensemble et notamment sa surface, et d'assurer une formation homogène et rapide du revêtement sur ce dernier. Un autre avantage du procédé selon l'invention est que le précurseur du revêtement peut lui aussi coupler avec le champ micro-ondes, ce qui augmente sa température et améliore aussi bien la cinétique de formation du revêtement que son homogénéité. Encore un autre avantage de l'invention est la réduction de l'énergie nécessaire pour former le revêtement, car on chauffe directement le segment de fibre et non plus un réacteur entier. Enfin, grâce à la polyvalence du procédé selon l'invention, la fibre peut être mise en présence du précurseur en phase liquide, en phase gazeuse, ou en phase supercritique.

On entend par « champ micro-ondes » un champ électromagnétique de fréquence comprise entre plusieurs centaines de MHz et plusieurs GHz. Le champ micro-ondes peut être caractérisé par sa puissance (ou amplitude) et sa fréquence, que l'homme du métier pourra déterminer aisément pour obtenir une température de surface des fibres courtes suffisante pour former le revêtement. Il existe en effet une multiplicité de couples fréquence/puissance qui permet d'obtenir un couplage suffisant entre le segment de fibre et le champ micro-ondes.

Dans un exemple de réalisation, le champ micro-ondes présente une fréquence principale comprise entre 2,35 GHz et 2,55 GHz.

Dans un exemple en dehors de l'invention, lors de l'étape de chauffage, le segment de fibre peut être en contact avec une phase liquide du précurseur du revêtement et le revêtement est formé par caléfaction. Dans cette configuration, la phase liquide du précurseur peut coupler avec le champ micro-ondes, ce qui augmente sa température, réduit la dissipation thermique autour du segment de fibre et améliore ainsi la cinétique de la caléfaction.

Dans un exemple en dehors de l'invention, lors de l'étape de chauffage, le segment de fibre peut être en présence d'une phase gazeuse du précurseur du revêtement et le revêtement peut être formé par infiltration chimique en phase gazeuse. Par rapport aux procédés de l'art antérieur mettant en oeuvre un précurseur gazeux et un dépôt par CVI, cet exemple de réalisation du procédé améliore la cinétique de formation et l'homogénéité du revêtement.

Dans un exemple en dehors de l'invention, la phase gazeuse du précurseur du revêtement peut être obtenue par l'ébullition d'une phase liquide du précurseur du revêtement, l'ébullition résultant du contact entre une portion chaude de la fibre contiqüe au segment présent dans le champ micro-ondes et la phase liquide du précurseur du revêtement. La portion de la fibre contigüe au revêtement est, dans cette situation, chauffée par conduction à partir du segment de fibre présent dans le champ micro-ondes. Cette technique permet de former le revêtement sur le segment de fibre à une pression réduite, égale ou légèrement supérieure à la pression atmosphérique. En outre, la paroi du réacteur dans lequel le dépôt est réalisé est dite froide par rapport à un réacteur de CVI dans lequel on doit chauffer les parois du réacteur, ce qui rend le procédé plus facile à mettre en oeuvre et plus économe en énergie. Cette technique de dépôt peut être vue comme une technique hybride entre la caléfaction et l'infiltration chimique en phase gazeuse.

Dans l'invention, lors de l'étape de chauffage, le segment de fibre est en présence d'une phase supercritique du précurseur du revêtement et le revêtement est formé par dépôt chimique en phase supercritique.

Dans un exemple de réalisation, lors du chauffage du segment de fibre, le segment peut être dans une première position, et le procédé peut comprendre en outre le défilement de la fibre de façon à déplacer le segment dans une deuxième position dans laquelle le segment est hors du champ micro-ondes. En d'autres termes, le procédé peut comprendre une étape de défilement de la fibre continue dans le champ micro-ondes. Cette disposition avantageuse permet de former le revêtement sur l'intégralité de la longueur de la fibre plus facilement.

Dans ce cas, le défilement de la fibre peut être effectué de façon continue ou semi-continue, en fonction des cinétiques de dépôts inhérentes aux variantes décrites précédemment ainsi qu'aux précurseurs mis en jeu.

Dans un exemple en dehors de l'invention, lorsqu'on utilise une phase liquide du précurseur, le segment de fibre peut être en contact avec la phase liquide du précurseur du revêtement lorsqu'il est dans la deuxième position. Cela signifie que la fibre défile en suivant un sens dans lequel elle plonge dans la phase liquide une fois qu'elle a été chauffée. Cette disposition est avantageuse car elle permet d'une part d'arrêter rapidement la formation du dépôt à la surface des filaments constituant le segment de fibre et d'autre part d'effectuer une trempe du segment de fibre juste après la formation du revêtement sur ce dernier, ce qui assure une homogénéité du revêtement entre deux segments successifs, et donc sur l'ensemble de la fibre continue.

Dans un exemple de réalisation, le défilement de la fibre peut comprendre le déroulement de la fibre à partir d'un premier mandrin et l'enroulement de la fibre sur un deuxième mandrin.

Dans un exemple de réalisation, le revêtement peut être un revêtement d'interphase. L'interphase a une fonction de défragilisation du matériau composite qui favorise la déviation de fissures éventuelles parvenant à l'interphase après s'être propagées dans la matrice, empêchant ou retardant la rupture de fibres par de telles fissures. Cette interphase permet également de protéger la fibre du matériau de la matrice lors de sa formation.

En particulier, le revêtement peut comprendre du carbone pyrolytique (PyC), du nitrure de bore (BN) ou du carbure de silicium (SiC). Le revêtement d'interphase peut par exemple comprendre du Si₃N₄ ou du SiBN.

Dans un exemple de réalisation, la fibre peut être en carbure de silicium présentant une teneur en oxygène inférieure ou égale à 1% en pourcentage atomique. Par exemple une telle fibre peut être une fibre du type Hi-Nicalon type S commercialisées par la société japonaise NGS.

Mentionné en dehors de l'invention est un dispositif pour la mise en oeuvre d'un procédé de dépôt d'un revêtement sur une fibre continue à partir d'un précurseur du revêtement en phase liquide, en phase gazeuse ou en phase supercritique, le dispositif comprenant un générateur de micro-ondes configuré pour générer un champ micro-ondes, un réacteur configuré pour être traversé par la fibre continue et pour contenir le précurseur du revêtement, au moins une partie dudit réacteur étant destinée à être dans le champ micro-ondes du générateur de micro-ondes, et un dispositif de défilement de la fibre à l'intérieur du réacteur. Le dispositif de défilement de la fibre peut être préférentiellement situé à l'extérieur du champ micro-ondes. On peut veiller à ce que la partie du réacteur dans le champ micro-ondes est présente au sein d'un ventre dudit champ.

Dans un exemple de réalisation, le réacteur peut présenter sensiblement une forme de U. Le réacteur peut être un tube. Dans ce cas, seule une partie d'une branche ou partie verticale du réacteur peut être présente dans le champ micro-ondes.

Dans un exemple de réalisation, notamment lorsque le réacteur a une forme de U, le réacteur peut comprendre au moins un élément de centrage de la fibre dans le réacteur. Un élément de centrage peut être présent en entrée et/ou en sortie du réacteur. Dans un réacteur en U, deux éléments de centrage peuvent être présents dans le réacteur au niveau des jonctions entre la portion horizontale et les portions verticales du U.

Dans un exemple de réalisation, le dispositif de défilement peut comprendre un premier mandrin à partir duquel la fibre est destinée à être déroulée et un deuxième mandrin sur lequel la fibre est destinée à être enroulée.

Dans un exemple de réalisation, le champ micro-ondes peut être obtenu à l'aide d'un résonateur présentant une cavité résonante. Dans ce cas le seul paramètre à régler pour moduler la température de surface des fibres est la puissance fournie au résonateur, car ce dernier possède généralement une fréquence de résonnance fixe. On peut veiller à ce que la fibre continue et le précurseur du revêtement soient placés au sein d'un ventre du champ micro-ondes, ce qui est le cas lorsque l'on utilise un tel résonateur et que l'on place la fibre et le précurseur au centre de sa cavité résonante. Bien entendu, d'autres moyens pour générer des micro-ondes peuvent être utilisés.

### Brève description des dessins

D'autres caractéristiques et avantages de la présente invention ressortiront de la description faite ci-dessous, en référence aux dessins annexés qui en illustrent des exemples de réalisation dépourvus de tout caractère limitatif. Sur les figures :
- la figure 1 montre un exemple très schématique de dispositif permettant de mettre en oeuvre un procédé selon un premier mode de réalisation, qui n'est pas selon l'invention,
- la figure 2 montre le dispositif de la figure 1 dans une configuration permettant de mettre en oeuvre un procédé selon un deuxième mode de réalisation, qui n'est pas selon l'invention, et
- la figure 3 montre un exemple très schématique de dispositif permettant de mettre en oeuvre un procédé selon un troisième ou un quatrième mode de réalisation, la troisième n'étant pas selon l'invention, la quatrième si est selon l'invention.

### Description détaillée de l'invention

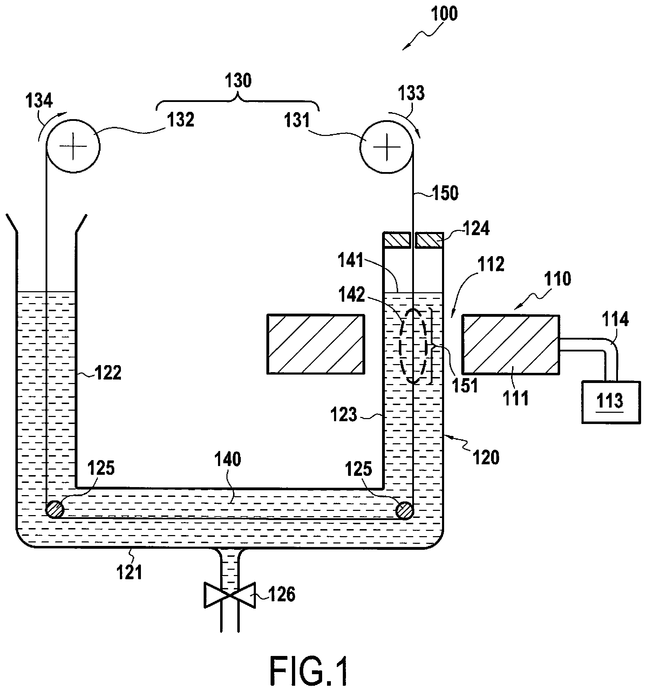

La figure 1 montre un dispositif 100, pour la mise en oeuvre d'un procédé selon un premier mode de réalisation de dit par caléfaction, c'est-à-dire dans lequel la formation du revêtement est réalisée en présence d'une phase liquide d'un précurseur du revêtement. Le dispositif 100 comprend un générateur de micro-ondes 110, un réacteur 120, et un dispositif de défilement 130.

Le générateur de micro-ondes 110 comprend ici un résonateur 111 muni d'une cavité résonante 112, le résonateur 111 est connecté à un générateur d'ondes 113 par un câble coaxial 114. En fonctionnement, la cavité résonante 112 est parcourue par un champ micro-ondes.

Le réacteur 120 peut être en un matériau transparent aux micro-ondes, par exemple en quartz. Le réacteur 120 prend ici la forme d'un tube en U ayant une partie horizontale 121, une première partie verticale 122 et une deuxième partie verticale 123. La deuxième partie verticale 123 du réacteur 120 est ici présente au moins en partie dans la cavité résonante 112 du résonateur 111, c'est-à-dire qu'elle traverse le résonateur 111.

Le réacteur 120 contient ici un précurseur du revêtement 140 en phase liquide. Dans cet exemple, le ménisque 141 du précurseur 140 se situe au-dessus de la cavité 112 du résonateur 111. En d'autres termes, la partie du réacteur 120 qui est présente dans la cavité 112 est remplie par la phase liquide du précurseur 140.

Le réacteur 120 est ici bouché à l'extrémité de la deuxième partie verticale 123 par un bouchon 124 percé d'un orifice central de manière à pouvoir être traversé par une fibre continue 150 en carbone ou en carbure de silicium. Le bouchon 121 joue également ici le rôle d'élément de centrage de la fibre 150 dans le réacteur. Le bouchon 121 peut être prévu pour permettre l'alimentation du réacteur 120 par la fibre 150. Le réacteur 120 est en outre pourvu de deux centreurs 125 présents respectivement aux deux jonctions entre la partie horizontale 121 et les deux parties verticales 122 et 123 du réacteur 120. Les centreurs 124 peuvent prendre la forme de petits rouleaux munis d'une gorge (non visibles sur les figures) qui ont pour fonction de maintenir la fibre 150 centrée dans le réacteur 120. Les centreurs 124 et 125 peuvent présenter une forme spécifique permettant l'étalement de la fibre afin d'améliorer l'homogénéité du dépôt sur les filaments présents dans la fibre, le cas échéant. Les centreurs 124 sont présents à l'intérieur du réacteur 120. Les centreurs 124 sont ainsi également des éléments de centrage de la fibre 150 dans le réacteur 120.

Dans l'exemple illustré, le réacteur 120 peut être pourvu d'une vanne de purge 126 et de moyens (non représentés) pour alimenter le réacteur en précurseur du revêtement 140 et maintenir un niveau constant de ce dernier dans le réacteur 120.

Le dispositif de défilement 130 comporte ici un premier mandrin 131 à partir duquel la fibre 150 peut être déroulée, le premier mandrin 131 peut être un mandrin de stockage de la fibre 150 avant qu'elle ne soit revêtue, et un deuxième mandrin 132 sur lequel la fibre 150 peut être enroulée une fois revêtue. La fibre 150 peut ainsi circuler dans le réacteur 120 depuis le premier mandrin 131 jusqu'au deuxième mandrin 132. Les éléments de centrage 124, 125 de la fibre 150 dans le réacteur 120 assurent ici que la fibre 150 ne touche pas la paroi du réacteur 120 et qu'elle est tendue. Le dispositif de défilement 130 peut être commandé par des moyens de commande non représentés, de façon à faire défiler la fibre 150 dans le dispositif 100 de façon continue ou semi-continue (c'est-à-dire pas à pas). Le dispositif de défilement 130 peut faire défiler la fibre 150 dans le dispositif 100 dans les deux sens.

Un premier mode de réalisation du procédé, qui n'est pas selon l'invention, va maintenant être décrit en lien avec ce dispositif 100. Lorsque le générateur de micro-ondes 110 est en fonctionnement, un champ micro-ondes est créé dans la cavité 112. Le dispositif de défilement 130 peut faire avancer la fibre 150 dans le dispositif sur une certaine distance de façon à ce qu'un segment 151 de la fibre 150 se trouve dans la cavité 112. Sous l'effet du couplage entre la fibre 150 et le champ micro-ondes, le segment 151 de fibre présent dans une zone 142 représentée en pointillés sur la figure 1 (cette zone étant située à l'intérieur de la cavité) est chauffé, et en particulier la surface du segment 151 de fibre chauffé atteint une température suffisante pour que le précurseur du revêtement 140 en phase liquide se vaporise localement autour du segment 151 de fibre et se dépose sur le segment 151 de fibre par caléfaction pour former le revêtement. Comme indiqué précédemment, l'homme du métier sait choisir les propriétés du champ micro-ondes, notamment sa fréquence et/ou sa puissance, pour atteindre la température de caléfaction du précurseur 140.

Dans l'exemple illustré, le dispositif de défilement 130 fait défiler la fibre 150 dans le dispositif 100 dans le sens indiqué par les flèches 133 et 134. Plus précisément, la fibre 150 défile ici de sorte qu'un segment 151 qui vient de passer dans le champ micro-ondes continue son chemin à l'intérieur du précurseur 140 en phase liquide. Cette disposition permet d'une part d'arrêter rapidement la formation du dépôt à la surface des filaments constituant le segment de fibre et d'autre part de réaliser une trempe du segment de fibre sur lequel le revêtement vient d'être formé, et assure une homogénéité de formation du revêtement sur l'ensemble de la fibre 150. Bien entendu, il est également possible de faire défiler la fibre 150 dans un sens opposé à celui illustré. La fibre 150 revêtue est ensuite récupérée à l'extrémité de la première partie verticale 122 du réacteur 120 par le deuxième mandrin 132 qui peut par exemple la stocker pour un usage ultérieur. En variante, la fibre 150 ainsi revêtue peut être directement utilisée pour fabriquer une préforme fibreuse par exemple par tissage.

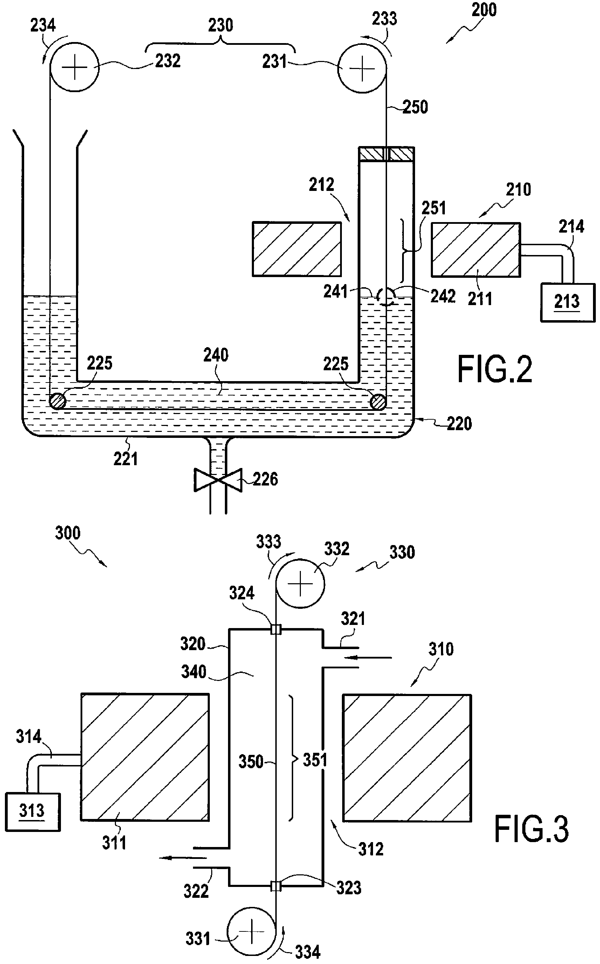

La figure 2 montre un dispositif 200 similaire au dispositif 100 de la figure 1 dans une configuration permettant de mettre en oeuvre un procédé selon un deuxième mode de réalisation, qui n'est pas selon l'invention. Dans ce mode de réalisation, le segment 251 de fibre est chauffé par le champ micro-ondes en présence d'une phase gazeuse du précurseur du revêtement obtenue par l'ébullition d'une phase liquide dudit précurseur. Sauf mention contraire, les signes de référence correspondant entre les figures 1 et 2 désignent des caractéristiques identiques qui ne seront pas décrites de nouveau.

Par rapport à la configuration du dispositif 100 montrée sur la figure 1, c'est l'emplacement du ménisque 241 du précurseur du revêtement 240 en phase liquide qui a été modifié, ainsi que le sens de défilement de la fibre 250. En effet, le ménisque 241 est désormais situé juste au-dessous de la cavité 212. En d'autres termes, la partie du réacteur 220 qui est présente dans la cavité 212 ne contient pas de phase liquide du précurseur 240. En outre, comme indiqué, le sens de défilement de la fibre 250 dans le dispositif 200 schématisé par les flèches 233 et 234 a été modifié.

Dans cet exemple, le ménisque 241 est positionné de sorte qu'une portion de fibre qui est contigüe au segment 251 de fibre présent dans le champ micro-ondes soit également chauffée par conduction thermique et permette l'évaporation (par ébullition) de la phase liquide du précurseur du revêtement 240 au niveau d'une zone 242 représentée en pointillés sur la figure 2. Le précurseur du revêtement qui s'est évaporé est désormais présent sous forme gazeuse dans la portion du réacteur 220 dépourvue de phase liquide 240 de précurseur du revêtement et présente dans le champ micro-ondes. Le segment 251 de fibre qui est présent dans le champ micro-ondes est chauffé à une température suffisante pour que le précurseur en phase gazeuse puisse se déposer sur le segment 251 de fibre et former le revêtement. Cette technique peut s'apparenter à une infiltration chimique en phase gazeuse couplée à de la caléfaction. Comme indiqué précédemment, l'homme du métier sait choisir les propriétés du champ micro-ondes, notamment sa fréquence et/ou sa puissance, pour atteindre la température adéquate à la surface du segment 251 de fibre pour former le revêtement à partir du précurseur du revêtement.

Dans cet exemple, le sens de défilement est de préférence celui illustré afin que suffisamment de précurseur du revêtement 240 en phase liquide soit évaporé, mais il est possible de faire défiler la fibre 250 dans le même sens que celui illustré sur la figure 1. Dans cet exemple la formation de revêtement peut ainsi être réalisée à une pression dans le réacteur 220 de l'ordre de la pression atmosphérique ou à une pression légèrement supérieure.

La figure 3 montre un troisième dispositif 300 pour mettre en oeuvre un procédé selon un troisième mode de réalisation, qui n'est pas selon l'invention, dans lequel le segment de fibre chauffé est en présence d'une phase gazeuse du précurseur du revêtement, ou selon un quatrième mode de réalisation, qui est selon l'invention, dans lequel le segment de fibre chauffé est en présence d'une phase supercritique du précurseur du revêtement. Le dispositif 300 comprend, de façon analogue au dispositif 100, un générateur de micro-ondes 310, un réacteur 320 et un dispositif de défilement 330.

Le générateur de micro-ondes comporte un résonateur 311 muni d'une cavité résonante 312, le résonateur 311 est connecté à un générateur d'ondes 313 par un câble coaxial 314. En fonctionnement, la cavité résonante 312 est parcourue par un champ micro-ondes.

Le dispositif 300 comprend en outre un réacteur 320 de forme cylindrique muni d'une entrée 321 et d'une sortie 322 pour le précurseur de revêtement. Le réacteur 320 peut être en un matériau transparent aux micro-ondes, par exemple en quartz. Au moins une partie du réacteur 320 est présente dans la cavité 312. Dans l'exemple illustré, l'entrée 321 et la sortie 322 du réacteur 320 sont situées de part et d'autres de la cavité 312. Le réacteur 320 contient ici un précurseur du revêtement 340 en phase gazeuse ou supercritique qui peut circuler dans le réacteur 320 entre l'entrée 321 et la sortie 322 du réacteur 320. Le réacteur 320 comprend en outre deux orifices 323 et 324 par lesquels une fibre 350 peut respectivement entrer et sortir du réacteur 320, les orifices 323 et 324 étant ici configurés pour ne pas laisser s'échapper le précurseur du revêtement 340 du réacteur 320.

Le dispositif de défilement 330 comporte ici un premier mandrin 331 à partir duquel la fibre 350 peut être déroulée, le premier mandrin 331 peut être un mandrin de stockage de la fibre 350 avant qu'elle ne soit revêtue, et un deuxième mandrin 332 sur lequel la fibre 350 peut être enroulée une fois revêtue. La fibre 350 peut ainsi circuler dans le réacteur 320 depuis le premier mandrin 331 jusqu'au deuxième mandrin 332. Le dispositif de défilement 330 peut être commandé par des moyens de commande non représentés, de façon à faire défiler la fibre 350 dans le dispositif 300 de façon continue ou semi-continue (c'est-à-dire pas à pas). Le dispositif de défilement 330 peut faire défiler la fibre 350 dans le dispositif 200 dans les deux sens. Dans l'exemple illustré, la fibre 350 défile de bas en haut (flèches 333 et 334), c'est-à-dire dans un sens opposé à la circulation de la phase gazeuse du précurseur du revêtement dans le dispositif 300. Ce sens de défilement particulier permet d'augmenter encore la cinétique de dépôt du revêtement.

Dans ce dispositif 300, de façon analogue aux dispositifs 100 et 200, le segment 351 de fibre 350 présent dans le champ micro-ondes est chauffé de sorte que sa surface atteigne une température suffisante pour que le précurseur en phase gazeuse ou supercritique se dépose sur le segment 351 de fibre pour assurer la formation du le revêtement. Comme indiqué précédemment, l'homme du métier sait choisir les propriétés du champ micro-ondes, notamment sa fréquence et/ou sa puissance, pour atteindre la température adéquate à la surface du segment 351 de fibre pour former le revêtement à partir du précurseur du revêtement. Selon que le segment 351 de fibre est en présence d'une phase gazeuse ou d'une phase supercritique du précurseur du revêtement, on peut désigner respectivement chaque technique de formation du revêtement d'infiltration chimique en phase gazeuse ou de dépôt chimique en phase supercritique. L'homme du métier sait choisir les conditions, notamment de température et de pression, du précurseur du revêtement, pour assurer la formation du revêtement sur le segment 351 de fibre. Un avantage dans ce cas est que les parois du réacteur 320 sont froides en comparaison avec des réacteurs utilisés dans l'art antérieur pour réaliser par exemple une infiltration chimique en phase gazeuse. Le fait de travailler en paroi froide offre l'opportunité de s'affranchir des conditions opératoires standards d'un procédé CVI classique, et permet d'atteindre des cinétiques de dépôt significativement plus élevées, jusqu'à deux ordres de grandeurs supérieures.

Dans tous les exemples présentés, l'épaisseur du revêtement formé sur le segment 151, 251, 351 de fibre dépend, toutes choses étant égales par ailleurs, du temps de séjour du segment 151, 251, 351 de fibre dans le champ micro-ondes en présence du précurseur du revêtement.

Dans tous les exemples présentés, le revêtement peut être un revêtement d'interphase, par exemple en carbure de silicium, en nitrure de bore ou en carbone pyrolytique. On peut former par exemple une interphase en carbone pyrolytique à l'aide d'un précurseur du revêtement tel qu'un alcool, comme de l'éthanol, un polyalcool ou du toluène. On peut former par exemple une interphase en carbure de silicium à l'aide d'un précurseur du revêtement tel que le méthyltrichlorosilane ou le diméthylchlorosilane. On peut former par exemple une interphase en nitrure de bore à l'aide d'un précurseur du revêtement tel que la borazine, ou un mélange de BCl₃ et de NH₃.

Les dispositifs 100, 200 et 300 ont été présentés comme pouvant accueillir une unique fibre 150, 250, 350. Bien entendu, on peut réaliser le procédé sur plusieurs fibres continues en même temps, par exemple en alimentant les dispositifs 100, 200 et 300 avec des fils ou des torons comprenant plusieurs fibres.

La fibre continue revêtue par un procédé selon l'invention peut ensuite être utilisée pour fabriquer une préforme fibreuse, par exemple par tissage, qui peut enfin être densifiée par une matrice.

### Exemple (pas selon l'invention)

On dépose une interphase de pyrocarbone sur des fibres continues carbure de silicium par un procédé selon le premier mode de réalisation en dehors de l'invention, en utilisant le dispositif 200 décrit précédemment. Pour ce faire on utilise un toron de fibres en carbure de silicium Hi-Nicalon type S de diamètre 10 µm (diamètre moyen des filaments). Le précurseur du revêtement, de l'éthanol en phase liquide, est placé dans le réacteur 220 du dispositif 200 comme illustré sur la figure 2. Dans le générateur de micro-ondes utilisé, la cavité résonante du résonateur présente une fréquence propre de l'ordre de 2,45 GHz et est alimenté par une puissance 15 W. Le toron de fibres défile dans le dispositif 200 à une vitesse de 10 mm/min. On a obtenu des fibres revêtues d'une interphase de pyrocarbone homogène et déposée de façon continue.

## Revendications

1. Procédé de dépôt d'un revêtement sur une fibre continue (250 ; 350) en carbone ou en carbure de silicium à partir d'un précurseur du revêtement (240 ; 340), le procédé comprenant au moins :
le chauffage d'un segment (251 ; 351) de la fibre en présence du précurseur du revêtement dans un champ micro-ondes de façon à porter la surface du segment à une température permettant la formation du revêtement sur le segment à partir du précurseur du revêtement, **caractérisé en ce que** :
le segment (351) de fibre (350) est en présence d'une phase supercritique du précurseur du revêtement (340) et le revêtement est formé par dépôt chimique en phase supercritique.

2. Procédé selon la revendication 1, dans lequel, lors du chauffage du segment (251 ; 351) de fibre (250 ; 350), le segment est dans une première position, et le procédé comprend en outre le défilement de la fibre de façon à déplacer le segment dans une deuxième position dans laquelle le segment est hors du champ micro-ondes.

3. Procédé selon la revendication 2, dans lequel le défilement de la fibre (250 ; 350) est effectué de façon continue ou semi-continue.

4. Procédé selon la revendication 2 ou 3, dans lequel le défilement de la fibre (250 ; 350) comprend le déroulement de la fibre à partir d'un premier mandrin (231 ; 331) et l'enroulement de la fibre sur un deuxième mandrin (232 ; 332).

5. Procédé selon l'une quelconque des revendications 1 à 4, dans lequel le revêtement est un revêtement d'interphase.

6. Procédé selon la revendication 5, dans lequel le revêtement comprend du carbone pyrolytique, du nitrure de bore ou du carbure de silicium.

7. Procédé selon l'une quelconque des revendications 1 à 6, dans lequel la fibre (250 ; 350) est en carbure de silicium présentant une teneur en oxygène inférieure ou égale à 1% en pourcentage atomique.

## Patentansprüche

1. Verfahren zum Aufbringen einer Beschichtung auf eine kontinuierliche Faser (250; 350) aus Kohlenstoff oder Siliziumkarbid aus einem Vorläufer der Beschichtung (240; 340), wobei das Verfahren mindestens umfasst:
Erhitzen eines Segments (251; 351) der Faser in Gegenwart des Vorläufers der Beschichtung in einem Mikrowellenfeld, um die Oberfläche des Segments auf eine Temperatur zu bringen, welche die Bildung der Beschichtung auf dem Segment aus dem Vorläufer der Beschichtung ermöglicht, **dadurch gekennzeichnet, dass**:
das Segment (351) der Faser (350) in Gegenwart einer überkritischen Phase des Vorläufers der Beschichtung (340) ist und die Beschichtung durch chemische Abscheidung in überkritischer Phase gebildet ist.

2. Verfahren nach Anspruch 1, wobei das Segment beim Erhitzen des Segments (251; 351) aus einer Faser (250; 350) in einer ersten Position ist und das Verfahren ferner das Bewegen der Faser umfasst, um das Segment in eine zweite Position zu verschieben, in der das Segment außerhalb des Mikrowellenfeldes ist.

3. Verfahren nach Anspruch 2, wobei das Bewegen der Faser (250; 350) auf kontinuierliche oder halbkontinuierliche Weise bewirkt wird.

4. Verfahren nach Anspruch 2 oder 3, wobei das Bewegen der Faser (250; 350) das Abwickeln der Faser von einem ersten Dorn (231; 331) und Aufwickeln der Faser auf einen zweiten Dorn (232; 332) umfasst.

5. Verfahren nach einem der Ansprüche 1 bis 4, wobei die Beschichtung eine Zwischenphasenbeschichtung ist.

6. Verfahren nach Anspruch 5, wobei die Beschichtung pyrolytischen Kohlenstoff, Bornitrid oder Siliziumkarbid umfasst.

7. Verfahren nach einem der Ansprüche 1 bis 6, wobei die Faser (250; 350) aus Siliziumkarbid mit einem Sauerstoffgehalt von weniger als oder gleich 1 Atomprozent besteht.

## Claims

1. A process for depositing a coating on a continuous fibre (250; 350) of carbon or silicon carbide from a precursor of the coating (240; 340), the process comprising at least:
heating a segment (251; 351) of the fibre in the presence of the coating precursor in a microwave field so as to bring the surface of the segment to a temperature allowing the coating to form on the segment from the coating precursor, **characterized in that**:
the segment (351) of fibre (350) is in the presence of a supercritical phase of the precursor of the coating (340) and the coating is formed by supercritical phase chemical deposition.

2. The process as claimed in claim 1, wherein, when heating the segment (251; 351) of fibre (250; 350), the segment is in a first position, and the process further comprises running the fibre so as to move the segment to a second position in which the segment is out of the microwave field.

3. The process as claimed in claim 2, wherein the running of the fibre (250; 350) is carried out continuously or semi-continuously.

4. The process as claimed in claim 2 or 3, wherein the unwinding of the fibre (250; 350) comprises unwinding the fibre from a first mandrel (231; 331) and winding the fibre onto a second mandrel (232; 332).

5. The process as claimed in any one of claims 1 to 4, wherein the coating is an interphase coating.

6. The process as claimed in claim 5, wherein the coating comprises pyrolytic carbon, boron nitride or silicon carbide.

7. The process as claimed in any one of claims 1 to 6, wherein the fibre (250; 350) is silicon carbide having an oxygen content of less than or equal to 1 atomic percent.
